# EUROPÄISCHE PATENTSCHRIFT

(11) **EP 2 960 583 B1**
(45) Veröffentlichungstag und Bekanntmachung des Hinweises auf die Patenterteilung: **24.04.2019**
(21) Anmeldenummer: 15169761.2
(22) Anmeldetag: 29.05.2015
(51) Int. Cl.: F24C 3/10, F23Q 3/00

(54) **GASKOCHSTELLE UND HERD**
GAS COOKING EQUIPMENT AND OVEN
POSTE DE CUISSON ET CUISINIÈRE

(30) Priorität: 25.06.2014 ES 201430968
(43) Veröffentlichungstag der Anmeldung: 30.12.2015
(73) Patentinhaber: BSH Hausgeräte GmbH, 81739 München (DE)
(72) Erfinder: Andrade Soares, Paulo Marcos, 39108 Monpia (Piélagos) (ES); Cabarga Herrera, Alejandro, 39011 Santander (ES); Placer Maruri, Emilio, 39120 Liencres (ES); Saiz Gonzalez, Roberto, 39539 Santander (ES)

(56) Entgegenhaltungen:
- WO-A1-00/52391
- WO-A1-92/12384
- WO-A1-2006/093475
- WO-A2-01/57445
- WO-A2-2008/047222
- WO-A2-2008/117163
- DE-T2- 68 909 754
- GB-A- 1 162 838
- US-A- 5 924 860
- US-A1- 2012 282 560

## Beschreibung

Die vorliegende Erfindung betrifft eine Gaskochstelle und einen Herd.

Eine Gaskochstelle weist zumindest einen Gasbrenner und eine Zündeinrichtung zum Zünden des Gasbrenners auf. Um eine Beschädigung der Zündeinrichtung durch von dem Gasbrenner abgestrahlte Wärmestrahlung zu verhindern, kann zwischen dem Gasbrenner und der Zündeinrichtung eine Schutzeinrichtung vorgesehen sein.

Die EP 2 594 851 A2 beschreibt eine derartige Schutzeinrichtung in Form eines Abschirmblechs. Die Schutzeinrichtung weist eine L-Form auf und ist zwischen dem Gasbrenner und elektrischen Komponenten, wie beispielsweise einer Zündeinrichtung, der Gaskochstelle angeordnet.

Die WO 92/12384 A1 beschreibt einen Gasbrenner mit einem benachbart zu dem Gasbrenner angeordneten Zündelement. Das Zündelement weist einen Isolator auf.

Die DE 689 09 754 T2 beschreibt einen Gasbrenner mit einem Zündelement, das an dem Gasbrenner angebracht ist. Das Zündelement umfasst einen Isolator.

Die US 5,924,860 A beschreibt einen Gasbrenner, der ein isoliertes Zündelement aufweist.

Die WO 00/52391 A1 beschreibt ein Zündelement für einen Gasbrenner, wobei das Zündelement einen Isolator aufweist.

Die WO 2008/117163 A2 beschreibt eine Gaskochstelle mit einem Gasbrenner, einem Zündelement, einer Zündeinrichtung zum Zünden des Gasbrenners und einer Schutzeinrichtung, die nicht lösbar mit der Zündeinrichtung verbunden ist.

Die WO 2006/093475 A1 und die WO 2008/047222 A2 beschreiben jeweils eine Zündeinrichtung zum Zünden eines Gasbrenners. Die Zündeinrichtung ist dabei innerhalb eines Kunststoffgehäuses angeordnet.

Vor diesem Hintergrund besteht eine Aufgabe der vorliegenden Erfindung darin, eine verbesserte Gaskochstelle zur Verfügung zu stellen.

Demgemäß wird eine Gaskochstelle mit einem Gasbrenner, einem Zündelement, einer Zündeinrichtung zum Zünden des Gasbrenners und einer zwischen dem Gasbrenner und der Zündeinrichtung angeordneten Schutzeinrichtung vorgeschlagen. Die Zündeinrichtung ist dabei derart mit der Schutzeinrichtung verbunden, dass eine Verbindung der Zündeinrichtung und der Schutzeinrichtung nicht lösbar, insbesondere nicht zerstörungsfrei lösbar, ist, wobei an der Schutzeinrichtung Steckelemente zum Anschluss der Zündeinrichtung an das Zündelement vorgesehen sind, wobei die Schutzeinrichtung mehrere isolierende Luftkammern aufweist, wobei die Luftkammern mit einer Umgebung der Gaskochstelle verbunden sind, und wobei die Luftkammern um die Zündeinrichtung herum verteilt angeordnet sind.

Insbesondere ist die Zündeinrichtung in die Schutzeinrichtung integriert. Hierdurch wird eine besonders gute Abschirmung der Zündeinrichtung erreicht. Weiterhin kann die Montage der Zündeinrichtung und der Schutzeinrichtung an eine Bodenwanne der Gaskochstelle gleichzeitig erfolgen. Dies vereinfacht die Montage und macht zusätzliche Befestigungselemente verzichtbar. Unter "nicht lösbar" ist vorliegend zu verstehen, dass die Zündeinrichtung form- und/oder stoffschlüssig mit der Schutzeinrichtung verbunden ist. Beim Trennen der Zündeinrichtung von der Schutzeinrichtung werden insbesondere die Zündeinrichtung, die Schutzeinrichtung und/oder die Verbindung beschädigt. Die Verbindung ist vorzugsweise ein Grenzbereich zwischen der Schutzeinrichtung und der Zündeinrichtung. Die Verbindung kann integraler Bestandteil der Schutzeinrichtung sein. Insbesondere ist die Verbindung mit Material der Schutzeinrichtung gebildet.

Gemäß einer Ausführungsform ist die Schutzeinrichtung dazu eingerichtet, die Zündeinrichtung vor Wärmestrahlung und/oder elektromagnetischer Strahlung zu schützen.

Die Zündeinrichtung kann zusätzlich eine reflektierende Beschichtung aufweisen. Beispielsweise kann an der Zündeinrichtung eine Metallfolie angebracht sein.

Gemäß einer weiteren Ausführungsform ist die Schutzeinrichtung aus einem Kunststoffmaterial gefertigt.

Alternativ kann die Schutzeinrichtung aus einem Metallwerkstoff gefertigt sein. Vorzugsweise ist die Schutzeinrichtung aus einem hitzebeständigen Kunststoffmaterial, wie beispielsweise Polyetheretherketon gefertigt. Das Kunststoffmaterial kann faserverstärkt, insbesondere glasfaserverstärkt, sein.

Gemäß einer weiteren Ausführungsform ist die Zündeinrichtung in einem Spritzgussverfahren mit Material der Schutzeinrichtung umspritzt.

Hierzu kann die Zündeinrichtung beispielsweise in ein Spritzgusswerkzeug eingelegt und mit Kunststoffmaterial umspritzt werden. Hierdurch ist eine besonders gute Verbindung der Zündeinrichtung mit der Schutzeinrichtung gewährleistet. Vorzugsweise umschließt Material der Schutzeinrichtung die Zündeinrichtung vollständig. Dadurch ist die Zündeinrichtung besonders gut vor Verschmutzungen und Feuchtigkeit geschützt. Gemäß einer weiteren Ausführungsform ist die Zündeinrichtung in die Schutzeinrichtung eingegossen.

Hierzu wird die Zündeinrichtung beispielsweise in eine in der Schutzeinrichtung vorgesehene Ausnehmung oder Vertiefung eingelegt und anschließend mit einem duroplastischen Kunststoffharz vergossen.

Die Schutzeinrichtung weist mehrere Luftkammern auf. In den Luftkammern kann Luft zirkulieren. Die Luftkammern verbessern die Isolationswirkung der Schutzeinrichtung. Die Luftkammern sind um die Zündeinrichtung herum verteilt angeordnet.

Die isolierenden Luftkammern sind mit einer Umgebung der Gaskochstelle verbunden.

Hierdurch kann ein Luftaustausch stattfinden, wobei erwärmte Luft durch Frischluft ersetzt wird. Hierdurch wird ein zu starkes Aufheizen der sich in den Luftkammern befindlichen Luft verhindert.

Gemäß einer weiteren Ausführungsform sind an der Schutzeinrichtung erste Steckelemente zum Anschluss der Zündeinrichtung an ein Stromnetz vorgesehen.

Die ersten Steckelemente ragen vorzugsweise aus einer dem Gasbrenner abgewandten Rückseite der Schutzeinrichtung heraus.

An der Schutzeinrichtung sind zweite Steckelemente zum Anschluss der Zündeinrichtung an ein Zündelement des Gasbrenners vorgesehen.

Vorzugsweise ist jedem Gasbrenner ein derartiges Zündelement zugeordnet. Die Anzahl der zweiten Steckelemente richtet sich nach der Anzahl der Zündelemente bzw. nach der Anzahl der Gasbrenner.

Weiterhin wird ein Herd mit zumindest einer derartigen Gaskochstelle vorgeschlagen.

Der Herd ist insbesondere ein Gasherd. Vorzugsweise ist der Herd ein Haushaltsgerät.

Weitere mögliche Implementierungen der Gaskochstelle und/oder des Herds umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Gaskochstelle und/oder des Herds hinzufügen.

Weitere vorteilhafte Ausgestaltungen und Aspekte der Gaskochstelle und/oder des Herds sind Gegenstand der Unteransprüche sowie der im Folgenden beschriebenen Ausführungsbeispiele der Erfindung. Im Weiteren werden die Gaskochstelle und/oder der Herd anhand von bevorzugten Ausführungsformen unter Bezugnahme auf die beigelegten Figuren näher erläutert.
Fig. 1 zeigt eine schematische Ansicht einer Ausführungsform eines Herds;
Fig. 2 zeigt eine schematische perspektivische Ansicht einer Schutzeinrichtung einer Zündeinrichtung für eine Gaskochstelle des Herds gemäß der Fig. 1; und
Fig. 3 zeigt eine weitere schematische perspektivische Ansicht der Schutzeinrichtung gemäß der Fig. 2.

In den Figuren sind gleiche oder funktionsgleiche Elemente mit denselben Bezugszeichen versehen worden, sofern nichts anderes angegeben ist.

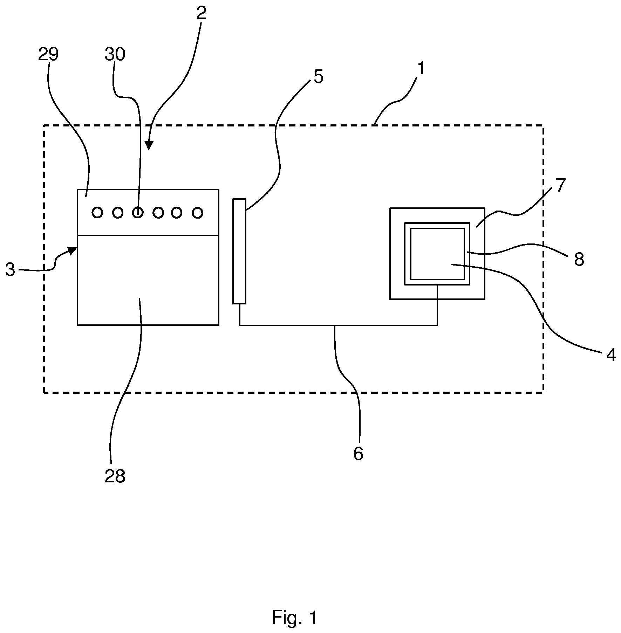

Die Fig. 1 zeigt in einer schematischen Ansicht einen Herd 1 mit einer Gaskochstelle 2. Der Herd 1 kann mehrere Gaskochstellen 2 aufweisen. Die Gaskochstelle 2 umfasst einen Gasbrenner 3. Der Gasbrenner 3 weist ein Brennergehäuse oder Brennerunterteil 28 und ein auf dem Brennerunterteil 28 angeordnetes Brenneroberteil 29 auf. An dem Brenneroberteil 29 sind Gasaustrittsöffnungen 30 vorgesehen. Die Gaskochstelle 2 kann auch mehrere Gasbrenner 3 umfassen. Weiterhin umfasst die Gaskochstelle 2 eine Zündeinrichtung 4 zum Zünden des Gasbrenners 3. Die Zündeinrichtung 4 kann ein benachbart zu dem Gasbrenner 3 angeordnetes Zündelement 5 umfassen. Das Zündelement 5 kann beispielsweise eine Zündkerze sein. Das Zündelement 5 ist dazu eingerichtet, aus den Gasaustrittsöffnungen 30 austretendes Brenngas zu entzünden.

Über eine elektrische Verbindung 6 ist das Zündelement 5 mit der Zündeinrichtung 4 verbunden.

Die Gaskochstelle 2 umfasst weiterhin eine Schutzeinrichtung 7. Die Schutzeinrichtung 7 ist zwischen dem Gasbrenner 3 und der Zündeinrichtung 4 angeordnet. Die Zündeinrichtung 4 ist form- und/oder stoffschlüssig mit der Schutzeinrichtung 7 verbunden. Wie die Fig. 1 zeigt, kann die Zündeinrichtung 4 vollständig von Material der Schutzeinrichtung 7 umgeben sein. Insbesondere ist die Zündeinrichtung 4 derart mit der Schutzeinrichtung 7 verbunden, dass eine Verbindung 8 der Zündeinrichtung 4 und der Schutzeinrichtung 7 nicht lösbar, insbesondere nicht zerstörungsfrei, lösbar ist. Ferner ist die Zündeinrichtung 4 derart mit der Schutzeinrichtung 7 verbunden, dass beim Entfernen der Zündeinrichtung 4 von der Schutzeinrichtung 7 die Verbindung 8, die Schutzeinrichtung 7 und/oder die Zündeinrichtung 4 beschädigt werden. Die Verbindung 8 ist ein Grenzbereich zwischen der Schutzeinrichtung 7 und der Zündeinrichtung 4. Die Verbindung 8 kann integraler Bestandteil der Schutzeinrichtung 7 sein. Insbesondere ist die Verbindung 8 aus Material der Schutzeinrichtung 7 gebildet.

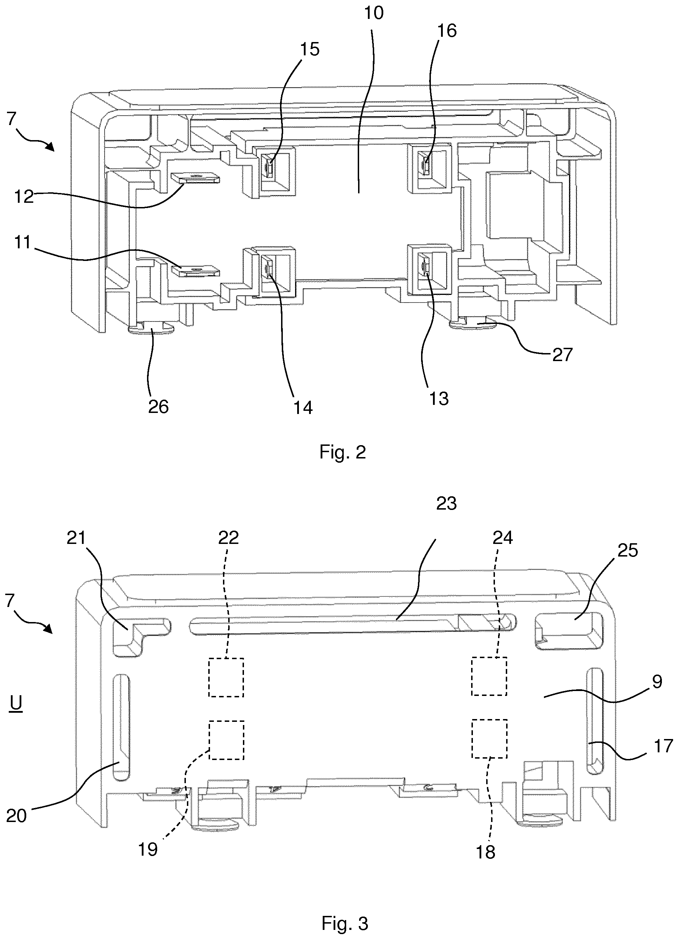

Die Fig. 2 und 3 zeigen die Schutzeinrichtung 7 mit der in die Schutzeinrichtung 7 integrierten Zündeinrichtung 4 jeweils in einer schematischen perspektivischen Ansicht. Die Schutzeinrichtung 7 ist vorzugsweise aus einem Kunststoffmaterial und/oder aus einem Metallwerkstoff gebildet. Die Schutzeinrichtung 7 weist eine dem Gasbrenner 3 zugewandte Vorderseite 9 und eine dem Gasbrenner 3 abgewandte Rückseite 10 auf.

Die Schutzeinrichtung 7 ist dazu eingerichtet, die Zündeinrichtung 4 vor Wärmestrahlung und/oder elektromagnetischer Strahlung zu schützen. Insbesondere kann die Zündeinrichtung 4 mit Material der Schutzeinrichtung 7 in einem Spritzgussverfahren, insbesondere in einem Kunststoff-Spritzgussverfahren, umspritzt sein. Alternativ kann die Zündeinrichtung 4 in die Schutzeinrichtung 7 eingegossen sein. Hierzu wird die Zündeinrichtung 4 beispielsweise in einen in der Schutzeinrichtung 7 vorgesehenen Hohlraum oder eine Ausnehmung eingelegt und mit einem Kunststoffharz vergossen. Die Zündeinrichtung 4 kann mit der Schutzeinrichtung verklebt sein.

An der Schutzeinrichtung 7 sind erste Steckelemente 11, 12 vorgesehen, mit Hilfe derer die Zündeinrichtung 4 an ein Stromnetz anschließbar ist. Die ersten Steckelemente 11, 12 ragen vorzugsweise aus der Rückseite 10 der Schutzeinrichtung 7 heraus. Weiterhin sind an der Schutzeinrichtung 7 zweite Steckelemente 13 bis 16 vorgesehen. Die zweiten Steckelemente 13 bis 16 sind zum Anschluss der Zündeinrichtung 4 an das Zündelement 5 des Gasbrenners 3 vorgesehen. Die Anzahl der zweiten Steckelemente 13 bis 16 ist beliebig. Die Anzahl der Steckelemente 13 bis 16 ist abhängig von der Anzahl der verwendeten Zündelemente 5 bzw. von der Anzahl der Gasbrenner 3.

Wie die Fig. 3 zeigt, weist die Schutzeinrichtung 7 zumindest eine isolierende Luftkammer 17 bis 25 auf. Die Anzahl der Luftkammern 17 bis 25 ist beliebig. Die Luftkammern 17 bis 25 wirken isolierend und verhindern oder reduzieren einen Wärmeeintrag von dem Gasbrenner auf die Zündeinrichtung 4. Insbesondere kann die Luft in den Luftkammern 17 bis 25 zirkulieren. Die isolierenden Luftkammern 17 bis 25 sind vorzugsweise mit einer Umgebung U der Gaskochstelle 2 verbunden.

Unterseitig an der Schutzeinrichtung 7 sind zwei pilzförmige Befestigungsabschnitte 26, 27 vorgesehen. Mit Hilfe der Befestigungsabschnitte 26, 27 kann die Schutzeinrichtung an einer Bodenwanne oder Kochmuldenwanne der Gaskochstelle 2 befestigt werden. Hierzu können an der Bodenwanne entsprechende schlitzförmige Durchbrüche vorgesehen sein, in die die Befestigungsabschnitte 26, 27 einschiebbar sind.

### Verwendete Bezugszeichen:

- 1: Herd
- 2: Gaskochstelle
- 3: Gasbrenner
- 4: Zündeinrichtung
- 5: Zündelement
- 6: Verbindung
- 7: Schutzeinrichtung
- 8: Verbindung
- 9: Vorderseite
- 10: Rückseite
- 11: Steckelement
- 12: Steckelement
- 13: Steckelement
- 14: Steckelement
- 15: Steckelement
- 16: Steckelement
- 17: Luftkammer
- 18: Luftkammer
- 19: Luftkammer
- 20: Luftkammer
- 21: Luftkammer
- 22: Luftkammer
- 23: Luftkammer
- 24: Luftkammer
- 25: Luftkammer
- 26: Befestigungsabschnitt
- 27: Befestigungsabschnitt
- 28: Brennerunterteil
- 29: Brenneroberteil
- 30: Gasaustrittsöffnungen

- U: Umgebung

## Patentansprüche

1. Gaskochstelle (2) mit einem Gasbrenner (3), einem Zündelement (5), einer Zündeinrichtung (4) zum Zünden des Gasbrenners (3) und einer zwischen dem Gasbrenner (3) und der Zündeinrichtung (4) angeordneten Schutzeinrichtung (7), wobei die Zündeinrichtung (4) derart mit der Schutzeinrichtung (7) verbunden ist, dass eine Verbindung (8) der Zündeinrichtung (4) und der Schutzeinrichtung (7) nicht lösbar, insbesondere nicht zerstörungsfrei lösbar, ist, wobei an der Schutzeinrichtung (7) Steckelemente (13 - 16) zum Anschluss der Zündeinrichtung (4) an das Zündelement (5) vorgesehen sind,
**dadurch gekennzeichnet, dass** die Schutzeinrichtung (7) zusätzlich mehrere isolierende Luftkammern (17 - 25) aufweist, wobei die Luftkammern (17 - 25) mit einer Umgebung (U) der Gaskochstelle (2) verbunden sind, und wobei die Luftkammern (17 - 25) um die Zündeinrichtung (4) herum verteilt angeordnet sind.

2. Gaskochstelle nach Anspruch 1, **dadurch gekennzeichnet, dass** die Schutzeinrichtung (7) dazu eingerichtet ist, die Zündeinrichtung (4) vor Wärmestrahlung und/oder elektromagnetischer Strahlung zu schützen.

3. Gaskochstelle nach Anspruch 1 oder 2, **dadurch gekennzeichnet, dass** die Schutzeinrichtung (7) aus einem Kunststoffmaterial gefertigt ist.

4. Gaskochstelle nach einem der Ansprüche 1 - 3, **dadurch gekennzeichnet, dass** die Zündeinrichtung (4) in einem Spritzgussverfahren mit Material der Schutzeinrichtung (7) umspritzt ist.

5. Gaskochstelle nach einem der Ansprüche 1 - 3, **dadurch gekennzeichnet, dass** die Zündeinrichtung (4) in die Schutzeinrichtung (7) eingegossen ist.

6. Gaskochstelle nach einem der Ansprüche 1 - 5, **dadurch gekennzeichnet, dass** an der Schutzeinrichtung (7) erste Steckelemente (11, 12) zum Anschluss der Zündeinrichtung (4) an ein Stromnetz vorgesehen sind.

7. Herd (1) mit zumindest einer Gaskochstelle (2) nach einem der Ansprüche 1 - 6.

## Claims

1. Gas cooking zone (2) with a gas burner (3), an ignition element (5), an ignition device (4) for igniting the gas burner (3) and a protection device (7) arranged between the gas burner (3) and the ignition device (4), wherein the ignition device (4) is connected to the protection device (7) such that a connection (8) of the ignition device (4) and the protection device (7) cannot be released, in particular cannot be released non-destructively, wherein provided on the protection device (7) are plug elements (13 - 16) for connecting the ignition device (4) to the ignition element (5),
**characterised in that** the protection device (7) additionally has a plurality of insulating air chambers (17 - 25), wherein the air chambers (17 - 25) are connected to a surrounding environment (U) of the gas cooking zone (2), and wherein the air chambers (17 - 25) are arranged distributed around the ignition device (4).

2. Gas cooking zone according to claim 1, **characterised in that** the protection device (7) is configured to protect the ignition device (4) from thermal radiation and/or electromagnetic radiation.

3. Gas cooking zone according to claim 1 or 2, **characterised in that** the protection device (7) is manufactured from a plastic material.

4. Gas cooking zone according to one of claims 1 - 3, **characterised in that** the ignition device (4) is overmoulded with the material of the protection device (7) in an injection-moulding process.

5. Gas cooking zone according to one of claims 1 - 3, **characterised in that** the ignition device (4) is cast into the protection device (7).

6. Gas cooking zone according to one of claims 1 - 5, **characterised in that** provided on the protection device (7) are first plug elements (11, 12) for connecting the ignition device (4) to a power supply system.

7. Cooker (1) with at least one gas cooking zone (2) according to one of claims 1 - 6.

## Revendications

1. Poste de cuisson à gaz (2) avec un brûleur à gaz (3), un élément d'allumage (5), un dispositif d'allumage (4) pour l'allumage du brûleur à gaz (3) et un dispositif de protection (7) disposé entre le brûleur à gaz (3) et le dispositif d'allumage (4), dans lequel le dispositif d'allumage (4) est relié de telle façon au dispositif de protection (7) qu'une liaison (8) entre le dispositif d'allumage (4) et le dispositif de protection (7) n'est pas amovible, en particulier n'est pas amovible sans destruction, dans lequel des éléments emboîtables (13 - 16) sont prévus sur le dispositif de protection (7) pour le raccordement du dispositif d'allumage (4) à l'élément d'allumage (5), **caractérisé en ce que** le dispositif de protection (7) présente en outre plusieurs chambres à air isolantes (17 - 25), les chambres à air (17 - 25) étant reliées à un environnement (U) du poste de cuisson à gaz (2) et les chambres à air (17 - 25) étant réparties autour du dispositif d'allumage (4).

2. Poste de cuisson à gaz selon la revendication 1, **caractérisé en ce que** le dispositif de protection (7) est aménagé afin de protéger le dispositif d'allumage (4) de la radiation thermique et/ou électromagnétique.

3. Poste de cuisson à gaz selon la revendication 1 ou 2, **caractérisé en ce que** le dispositif de protection (7) est fabriqué en un matériau plastique.

4. Poste de cuisson à gaz selon l'une des revendications 1 à 3, **caractérisé en ce que** le dispositif d'allumage (4) est surmoulé lors d'un procédé de moulage par injection avec le matériau du dispositif de protection (7).

5. Poste de cuisson à gaz selon l'une des revendications 1 à 3, **caractérisé en ce que** le dispositif d'allumage (4) est coulé dans le dispositif de protection (7).

6. Poste de cuisson à gaz selon l'une des revendications 1 à 5, **caractérisé en ce que** de premiers éléments d'enfichage (11, 12) sont prévus sur le dispositif de protection (7) pour le raccordement du dispositif d'allumage (4) à un réseau électrique.

7. Cuisinière (1) avec au moins un poste de cuisson à gaz (2) selon l'une des revendications 1 à 6.
